# EUROPÄISCHE PATENTSCHRIFT

(11) **EP 3 849 805 B1**
(45) Veröffentlichungstag und Bekanntmachung des Hinweises auf die Patenterteilung: **26.10.2022**
(21) Anmeldenummer: 19769141.3
(22) Anmeldetag: 13.09.2019
(51) Int. Cl.: B23K 15/00, B33Y 10/00, H01J 37/304, H01J 37/30, B33Y 40/00, B33Y 30/00

(54) **VERFAHREN ZUM GLÄTTEN EINES BAUTEILOBERFLÄCHENBEREICHS**
METHOD FOR SMOOTHING A COMPONENT SURFACE REGION
PROCÉDÉ DESTINÉ À LISSER UNE ZONE SUPERFICIELLE DE COMPOSANT

(30) Priorität: 14.09.2018 DE 102018122605
(43) Veröffentlichungstag der Anmeldung: 21.07.2021
(73) Patentinhaber: Fraunhofer-Gesellschaft zur Förderung der angewandten Forschung e.V., 80686 München (DE)
(72) Erfinder: GRAFFEL, Benjamin, 01277 Dresden (DE); WINCKLER, Falk, 01277 Dresden (DE); FRITZSCHE, Sven, 01277 Dresden (DE); KIEBACK, Bernd, 01277 Dresden (DE); KLÖDEN, Burghardt, 01277 Dresden (DE); WEISSGÄRBER, Thomas, 01277 Dresden (DE)
(86) Internationale Anmeldenummer: PCT/EP2019/074525
(87) Internationale Veröffentlichungsnummer: WO 2020/053407

(56) Entgegenhaltungen:
- US-A1- 2015 037 601
- US-A1- 2017 355 147
- US-A1- 2018 117 851

## Beschreibung

Die Erfindung betrifft ein Verfahren zum Glätten von Bauteiloberflächen, die aus einem elektrisch leitfähigen Material bestehen.

Das Herstellen von Bauteilen mittels sogenannter additiver Fertigung erlangt eine zunehmende Bedeutung. Hierbei erfolgt ein lagenweiser Aufbau eines Bauteils durch lokales Aufschmelzen von Pulvern mittels eines Laser- oder Elektronenstrahls. Derartig gefertigte Bauteile können sehr komplexe innere Strukturen sowie kompliziert geformte Oberflächen (Freiformflächen) besitzen, die mit traditionellen, subtraktiven Verfahren in dieser Form oftmals nicht herstellbar sind. Insbesondere für den Leichtbau in der Luft- und Raumfahrt sowie der Medizintechnik eröffnen sich auf diese Weise völlig neue Einsatz- und Gestaltungsmöglichkeiten.

In US 2015/0037601 wird vorgeschlagen, ein 3D-Bauteil schichtweise aufwachsen zu lassen, indem eine Pulverschicht nach der anderen, übereinanderliegend mittels eines Energiestrahls, aufgeschmolzen wird. Nach dem Aufschmelzen einer Pulverschicht wird die Oberflächenstruktur des bis dahin realisierten 3D-Bauteils mit einem Elektronenstrahl überstrichen und durch eine Auswertung der Rückstreuelektronen eine Aussage getroffen, ob die bisher erzielte Oberflächenstruktur bereits mit der Sollvorgabe übereinstimmt. Wenn dies nicht der Fall ist, wird eine nächste Pulverschicht aufgeschmolzen.

Ein besonderer Nachteil additiv gefertigter Bauteile ist jedoch die besonders raue Oberfläche nach dem Herstellungsprozess. Raue Oberflächen entstehen bei diesen Fertigungsverfahren, weil der schichtweise Aufwachsprozess im Pulverbett zusätzlich auch noch mit einem Anhaften nicht vollständig geschmolzener Pulverpartikel einhergeht. Die rauen Oberflächen additiv hergestellter Bauteile erschweren bisher deren Einsatz.

Vorrichtungen und Verfahren zum additiven Fertigen dreidimensionaler Objekte sind auch aus US 2017/0355147 A1 und US 2018/0117851 A1 bekannt. Bei diesen Vorrichtungen kann die Rauheit einer Oberfläche durch das Auswerten eines Rückstreusignals einer elektromagnetischen Strahlung oder auch u.a. einer Elektronenstrahlung ermittelt und der weitere schichtweise Aufwuchs der dreidimensionalen Objekte in Abhängigkeit vom ausgewerteten Rückstreusignal gesteuert werden.

Ein bekannter Ansatz zum Verringern der Oberflächenrauheit additiv gefertigter Bauteile beinhaltet das Verwenden feinerer Pulver, was jedoch die Geschwindigkeit und damit die Produktivität des Herstellungsprozesses verringert. Das Glätten der Oberflächen additiv hergestellter Bauteil mittels materialabtragender mechanischer Verfahren scheitert oftmals an der filigranen Freiformoberflächenstruktur eines Bauteils.

Bei alternativen Verfahren zum Glätten von Oberflächen wird die Oberfläche eines Bauteils vollständig oder teilweise mittels eines Laser- oder Elektronenstrahls aufgeschmolzen bzw. abgedampft. In WO 1996/31315 A1 wird beispielsweise zum Glätten und Polieren einer Bauteiloberfläche die Oberfläche des Bauteils zunächst mit einer Konturmesseinrichtung abgetastet und dadurch ein Istzustand der Bauteilform erfasst, welcher mit einem Sollzustand verglichen und in Abhängigkeit vom Vergleichsergebnis ein Signal gebildet wird, mit welchem ein Laserstahl zum Aufschmelzen der Bauteiloberfläche angesteuert wird. Zum Abtasten der Bauteiloberfläche werden dabei optische Systeme unter Verwendung eines Lasers oder mechanisches Abtasten vorgeschlagen.

In DE 2654486 A1 wird ein Verfahren offenbart, bei dem die raue Oberfläche eines gestanzten Nadelöhrs durch Bestrahlen mit einem Elektronenstrahl oder einem Laser aufgeschmolzen und so geglättet wird. Die Schrift zeigt damit die prinzipielle Wirksamkeit der Oberflächenglättung durch lokales Aufschmelzen. Das Verfahren ermöglicht jedoch keine lokal angepasste Glättung beliebiger, komplex geformter, dreidimensionaler Körper. Insbesondere erfolgt keine Erfassung des Oberflächenprofils und der Rauheit der Oberfläche.

Beim Bearbeiten komplex geformter Bauteile und/oder der lokal unterschiedlichen Bearbeitung einer Oberfläche ist das Anpassen der Strahlparameter speziell für den momentan bearbeiteten Oberflächenbereich in Bezug auf das beabsichtigte Bearbeitungsergebnis erforderlich. Ein Beispiel für das Anpassen der Laserstrahlintensität beim Härten von Kurbelwellen ist in DE 3905551 A1 beschrieben. Laserstrahl und Werkstück werden dabei relativ zueinander bewegt und die Laserintensität in Abhängigkeit von der vom Laserstrahl überstrichenen Oberflächengeometrie und der gewünschten Eindringtiefe moduliert. Neben einer Härtung ist so auch ein Glätten der Oberflächenbereiche möglich. Die Geschwindigkeit der Relativbewegung wird dabei durch das berührungslose Messen der Oberflächentemperatur reguliert. Das Verfahren offenbart jedoch keine Möglichkeit zur Detektion der Kontur und Rauheit einer kompliziert geformten Freiformfläche.

Der Erfindung liegt daher das technische Problem zugrunde, ein Verfahren zum Glätten von Bauteiloberflächen zu schaffen, mittels dessen die Nachteile aus dem Stand der Technik überwunden werden können. Insbesondere soll es mit dem erfindungsgemäßen Verfahren auch möglich sein, den Istzustand bezüglich der Rauheit einer Bauteiloberfläche zu erfassen und davon technische Parameter für das Glätten der Bauteiloberfläche abzuleiten.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren zum Glätten eines Oberflächenbereichs eines Bauteils, welches zumindest innerhalb des Oberflächenbereichs aus einem elektrisch leitfähigen Material besteht, wird der Oberflächenbereich des Bauteils innerhalb einer Vakuumkammer mittels mindestens eines fokussierten Elektronenstrahls aufgeschmolzen. Das Aufschmelzen des Oberflächenbereichs erfolgt, indem der Oberflächenbereich mit dem Elektronenstrahl mit einer ersten Flächenenergie überstrichen wird, welche ein Aufschmelzen des Oberflächenbereichs bewirkt. Unter Flächenenergie ist die Energie pro Fläche zu verstehen, die mittels des Elektronenstrahls in das mit dem Elektronenstrahl zu bearbeitende Bauteil eingebracht wird. Die Flächenenergie ist abhängig von der Verweildauer des Elektronenstrahls innerhalb des Oberflächenbereichs und von der Intensität des Elektronenstrahls.

Das Überstreichen eines Bauteiloberflächenbereichs mit einem Elektronenstrahl mit einer zweiten Flächenenergie wird nachfolgend auch verkürzt als Scannen des Oberflächenbereichs bezeichnet.

Bevor jedoch der Oberflächenbereich des Bauteils mittels des Elektronenstrahls aufgeschmolzen wird, wird beim erfindungsgemäßen Verfahren zunächst ein Istzustand der Rauheit innerhalb des Oberflächenbereichs ermittelt und mit einem Sollzustand der Rauheit innerhalb des Oberflächenbereichs verglichen.

Hierfür wird der Oberflächenbereich vor dem Aufschmelzen mindestens zweimal mit einem Elektronenstrahl überstrichen, jedoch mit einer zweiten Flächenenergie, welche kein Aufschmelzen des Bauteilmaterials im Oberflächenbereich bewirkt. Welche Flächenenergie das Aufschmelzen eines Oberflächenbereichs eines Bauteils bewirkt und welche nicht, ist vom Material und der Form des Bauteils abhängig, lässt sich jedoch mittels Laborversuchen einfach ermitteln. Erfindungswesentlich ist, dass das mindestens zweimalige Überstreichen des Oberflächenbereichs mittels des Elektronenstrahls mit der zweiten Flächenenergie jeweils mit einer anderen Fokuslänge des Elektronenstrahls durchgeführt wird.

Innerhalb der Vakuumkammer, in welcher das Bauteil mittels des Elektronenstrahls bearbeitet wird, wird eine Anzahl von Sensoren angeordnet. Diese Sensoren werden innerhalb der Vakuumkammer verteilt und oberhalb des mittels des Elektronenstrahls zu bearbeitenden Oberflächenbereichs derart angeordnet, dass Rückstreuelektronen des Elektronenstrahls und aus dem Material des Bauteils herausgelöste Sekundärelektronen auf die Sensoren auftreffen können. Mittels der Sensoren werden somit während des Überstreichens des Oberflächenbereichs mittels des Elektronenstrahls mit der zweiten Flächenenergie Daten erfasst, die den elektrischen Strom, hervorgerufen durch die auf die Sensoren auftreffenden Rückstreuelektronen und Sekundärelektronen, charakterisieren. Es werden Daten erfasst, welche die Stromstärke an einem jeweiligen Sensor, hervorgerufen durch die auf den Sensor auftreffenden Rückstreuelektronen und Sekundärelektronen, charakterisieren.

Die mittels der Sensoren erfassten Daten werden an eine Auswerteeinrichtung übermittelt, mittels welcher ein Istwert für die Rauheit innerhalb des Oberflächenbereichs ermittelt wird. Da sich die Bahnen der Elektronen aus dem Elektronenstrahl und die Bahnen der von der Oberfläche reflektierten Rückstreuelektronen überwiegend entsprechend des optischen Gesetzes "Einfallswinkel gleich Ausfallswinkel" verhalten, werden die Rückstreuelektronen beim Überstreichen des Oberflächenbereichs mit der zweiten Flächenenergie bei einer rauen Oberfläche in verschiedene Richtungen reflektiert und somit auch von mehreren Sensoren an verschiedenen Positionen erfasst. Je mehr der innerhalb der Vakuumkammer angeordneten Sensoren beim Überstreichen des Oberflächenbereichs mittels des Elektronenstrahls mit der zweiten Flächenenergie das Auftreffen von Rückstreuelektronen erfassen, umso rauer ist die Oberfläche innerhalb des Oberflächenbereichs. Wenn jedoch nur wenige Sensoren oder gar nur ein Sensor das Auftreffen von Rückstreuelektronen anzeigt bzw. die von den Sensoren erfasste Stromstärke an einem Sensor oder an sehr wenigen Sensoren einen Peak aufweist, ist die Rauheit innerhalb des Oberflächenbereichs gering. Auf diese Weise kann mittels der von den Sensoren erfassten Daten eine Aussage bezüglich der aktuellen Rauheit getroffen, also ein Istwert für die Rauheit innerhalb des Oberflächenbereichs ermittelt werden. Je größer die Anzahl der in der Vakuumkammer angeordneten Sensoren ist, umso präziser können Aussagen bezüglich der Rauheit innerhalb des Oberflächenbereichs abgeleitet werden. Die Sensoren können auch in Form eines Sensor-Arrays angeordnet werden. Es können aber auch schon mit mindestens zwei Sensoren qualitative Aussagen bezüglich der Rauheit innerhalb des Oberflächenbereichs abgeleitet werden.

Damit Rückstreuelektronen und Sekundärelektronen mittels der Sensoren, die sich außerhalb des Strahlbereiches des Elektronenstrahls befinden müssen, in Abhängigkeit von der Rauheit der Oberfläche gut aufgelöst erfasst werden können, ist es vorteilhaft, wenn ein Einfallwinkel des Elektronenstrahls auf der Oberfläche des zu bearbeitenden Bauteils gewählt wird, der kleiner als 90° ist. Vorzugsweise wird ein Einfallwinkel des Elektronenstrahls auf der Oberfläche des zu bearbeitenden Bauteils in einem Bereich von 45° bis 90° gewählt.

Wie zuvor beschrieben, wird beim erfindungsgemäßen Verfahren ein Oberflächenbereich mindestens zweimal mittels eines Elektronenstrahls mit der zweiten Flächenenergie überstrichen, wobei jedes Mal eine andere Fokuslänge des Elektronenstrahls eingestellt wird. Es hat sich gezeigt, dass eine präzisere Aussage bezüglich der Rauheit innerhalb des Oberflächenbereichs abgeleitet werden kann, wenn der Oberflächenbereich mehrfach mit unterschiedlicher Fokuslänge gescannt wird und die mittels der Sensoren erfassten Daten eines Durchlaufs mit den Daten des nachfolgenden Durchlaufs bzw. mit den Daten nachfolgender Durchläufe, innerhalb der Auswerteeinrichtung mittels einer mathematischen Operation verknüpft werden und aus dem Verknüpfungsergebnis ein Istwert für die Rauheit abgeleitet wird. Die Daten der aufeinanderfolgenden Durchläufe können beispielsweise addiert werden.

Sind die von den Sensoren übermittelten Daten der aufeinanderfolgenden Durchläufe mittels der Auswerteeinrichtung zu einem Istwert für die Rauheit innerhalb des Oberflächenbereichs verarbeitet, wird dieser Istwert für die Rauheit innerhalb des Oberflächenbereichs mit einem Sollwert für die Rauheit innerhalb des Oberflächenbereichs verglichen. In Abhängigkeit vom Vergleichsergebnis wird dann mittels der Auswerteeinrichtung ein Wert für die erste Flächenenergie ermittelt, mit welcher der Elektronenstrahl anschließend den Oberflächenbereich des Bauteils überstreicht, um den Oberflächenbereich zum Zwecke des Glättens aufzuschmelzen. Dabei wird folgender Zusammenhang berücksichtigt. Je weniger der Istwert für die Rauheit innerhalb des Oberflächenbereichs vom Sollwert für die Rauheit innerhalb des Oberflächenbereichs abweicht, umso geringer wird der Wert für die erste Flächenenergie eingestellt. Umgekehrt bedeutet dies, je rauer der Oberflächenbereich noch ist, umso höher wird der Wert für die erste Flächenenergie eingestellt und umso tiefer wird der Oberflächenbereich mittels des Elektronenstrahls mit der ersten Flächenenergie aufgeschmolzen.

Nach dem Aufschmelzen des Oberflächenbereichs mittels des Elektronenstrahls mit der ersten Flächenenergie wird der Oberflächenbereich abermals mindestens zweimal mittels des Elektronenstrahls mit der zweiten Flächenenergie überstrichen, wobei das mindestens zweimalige Überstreichen auch wieder jedes Mal mit einer anderen Fokuslänge des Elektronenstrahls erfolgt. Es erfolgt das zuvor beschriebene Erfassen von Daten mittels der Sensoren, das Übermitteln der Daten an die Auswerteeinrichtung, das Ermitteln eines aktuellen Istwertes für die Rauheit im Oberflächenbereich, das Vergleichen des Istwertes für die Rauheit innerhalb des Oberflächenbereichs mit dem Sollwert für die Rauheit innerhalb des Oberflächenbereichs und das Einstellen des Wertes für die erste Flächenenergie in Abhängigkeit vom Vergleichsergebnis. Der beschriebene Kreislauf vom Scannen des Oberflächenbereichs mit dem nachfolgenden Aufschmelzen des Oberflächenbereichs wird so lange fortgeführt, bis der Istwert für die Rauheit innerhalb des Oberflächenbereichs den Sollwert für die Rauheit innerhalb des Oberflächenbereichs erreicht hat.

Mit jedem Aufschmelzen des Oberflächenbereichs nimmt die Rauheit innerhalb des Oberflächenbereichs ab, so dass für einen nachfolgenden Aufschmelzvorgang ein kleinerer Wert für die erste Flächenenergie eingestellt werden kann, wodurch der Oberflächenbereich im nachfolgenden Aufschmelzvorgang auch nur noch mit einer geringeren Tiefe aufgeschmolzen wird. Das zyklische Aufschmelzen des Oberflächenbereichs mit immer geringer werdender Aufschmelztiefe bewirkt schließlich ein Glätten der Oberfläche innerhalb des Oberflächenbereichs.

Bei einer Ausführungsform wird aus den von den Sensoren erfassten Daten mittels der Auswerteeinrichtung ein dreidimensionales Abbild vom Oberflächenbereich erzeugt.

Wenn der Oberflächenbereich des Bauteils, welcher mit dem Elektronenstrahl gescannt wird, keine ebene Fläche ist, sondern bauteilformbedingte Unebenheiten aufweist, hat das zur Folge, dass das dreidimensionale Abbild, welches aufgrund der mittels der Sensoren erfassten Daten innerhalb der Auswerteeinrichtung beim einmaligen Scannen mit einer Fokuslänge erzeugt wird, Oberflächenteilbereiche aufweist, in denen das dreidimensionale Abbild eine hohe Detailschärfe aufweist und Oberflächenteilbereiche, in denen das dreidimensionale Abbild nur eine geringe Detailschärfe aufweist. Erfindungsgemäß wird deshalb ein Oberflächenbereich auch mindestens zweimal mit jeweils unterschiedlicher Fokuslänge des Elektronenstrahls gescannt. Denn es hat sich gezeigt, dass bei Scannen eines Oberflächenbereichs mit anderen Fokuslängen des Elektronenstrahls auch jedes Mal andere Oberflächenteilbereiche beim dreidimensional erzeugten Abbild mit hoher Detailschärfe dargestellt werden.

Bei einer weiteren Ausführungsform der Erfindung werden deshalb bei jedem Scan eines Oberflächenbereichs eines Bauteils mit einem Elektronenstrahl, die von den Sensoren erfassten Daten an eine Auswerteeinrichtung übermittelt, mittels der Auswerteeinrichtung ein dreidimensionales Abbild des Oberflächenbereichs erzeugt, und mittels bekannter Grafiksoftware, die mit hoher Detailschärfe dargestellten Oberflächenteilbereiche aus dem dreidimensionalen Abbild herausgeschnitten und die auf diese Weise bei jedem Scan mit unterschiedlicher Fokuslänge des Elektronenstrahls gewonnenen unterschiedlichen Oberflächenteilbereiche mit hoher Detailschärfe wieder zu einem Gesamtabbild der Oberfläche zusammengesetzt. Auf diese Weise kann ein dreidimensionales Gesamtabbild des Oberflächenbereichs mit einer hohen Detailschärfe hergestellt werden. Je öfter ein Oberflächenbereich mit unterschiedlicher Fokuslänge des Elektronenstrahls gescannt wird umso detailgenauer kann ein dreidimensionales Abbild des Oberflächenbereichs mittels der Auswerteeinrichtung berechnet werden.

Aus den von den Sensoren erfassten Daten bzw. aus dem dreidimensionalen Gesamtabbild des Oberflächenbereichs mit hoher Detailschärfe lassen sich dann Angaben zur Oberflächenform innerhalb des Oberflächenbereichs, zur Ausrichtung des Oberflächenbereichs in Bezug zur Einfallsrichtung des Elektronenstrahls sowie zu einem Istwert der Rauheit innerhalb des Oberflächenbereichs ableiten.

Optional kann das mit einem Elektronenstrahl zu bearbeitende Bauteil mittels einer Halteeinrichtung innerhalb der Vakuumkammer angeordnet werden, welche die Position des Bauteils innerhalb der Vakuumkammer dreidimensional verändern kann. Ein Oberflächenbereich des Bauteils wird nach dem Anordnen mittels der Halteeinrichtung innerhalb der Vakuumkammer mittels des Elektronenstrahls mindestens zweimal mit unterschiedlicher Fokuslänge gescannt; mittels der dabei von den Sensoren erfassten Daten innerhalb der Auswerteeinrichtung ein dreidimensionales Abbild des Oberflächenbereichs erzeugt, aus dem dreidimensionalen Abbild eine Aussage zur dreidimensionalen Ist-Ausrichtung des Bauteils innerhalb der Vakuumkammer abgeleitet und mit einer Soll-Ausrichtung des Bauteils verglichen. In Abhängigkeit vom Vergleichsergebnis wird dann ein Signal gebildet, mit dem die Halteeinrichtung das Bauteil zur Soll-Ausrichtung innerhalb der Vakuumkammer führt.

Auf diese Weise ist es beispielsweise möglich, das Bauteil innerhalb der Vakuumkammer in eine gewünschte Startposition für das Bearbeiten mit dem Elektronenstrahl zu bringen oder auch eine Lageänderung des Bauteils vorzunehmen und nach erfolgter Lageänderung die aktuelle räumliche Anordnung des Bauteils zu überprüfen, wenn das Bauteil nach dem Bearbeiten eines Oberflächenbereichs zum Bearbeiten eines anderen Oberflächenbereichs in eine andere Position überführt werden soll.

Die vorliegende Erfindung wird nachfolgend anhand von Ausführungsbeispielen näher erläutert. Die Fig. zeigen:
- Fig. 1: eine schematische Darstellung einer Vorrichtung zum Ausführen des erfindungsgemäßen Verfahrens.
- Fig. 2a, 2b, 2c: eine schematische Darstellung einer Vorrichtung zum Ausführen einer alternativen Ausführungsform des erfindungsgemäßen Verfahrens.

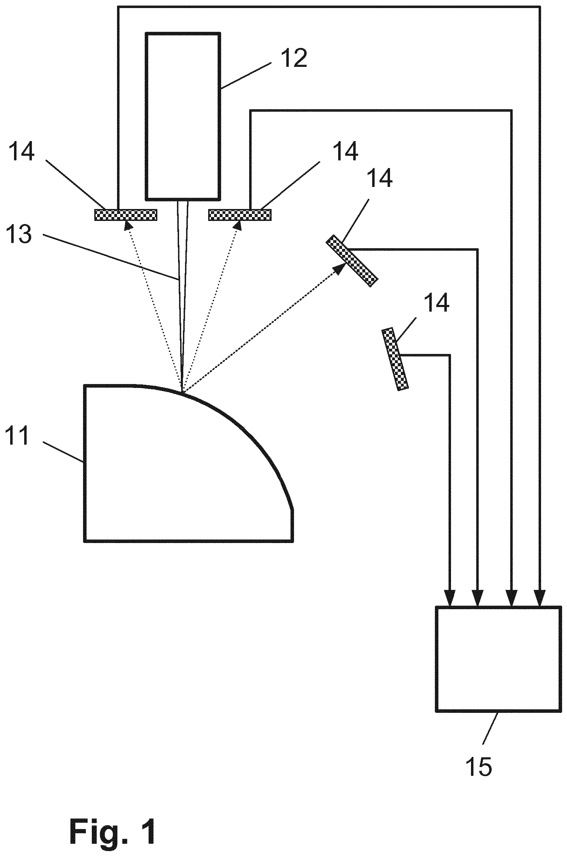

In Fig. 1 ist eine Vorrichtung schematisch dargestellt, mittels der das erfindungsgemäße Verfahren durchgeführt werden kann. Ein aus einem elektrisch leitfähigen Material bestehendes und beispielsweise mittels additiver Fertigung hergestelltes Bauteil 11, welches einen konstanten Querschnitt gemäß Fig. 1 aufweist und welches sich bezüglich seiner Längenausdehnung in die Tiefe der Zeichenebene von Fig. 1 erstreckt, weist an einer Seite eine konvex geformte Oberfläche auf. Da die konvex geformte Oberfläche eine zu hohe Rauheit aufweist, soll diese Oberfläche geglättet werden. Dazu wird das Bauteil 11 erfindungsgemäß in eine Vakuumkammer eingeschleust. In der Vakuumkammer angeordnet oder an der Vakuumkammer befestigt ist mindestens ein Elektronenstrahlgenerator 12, zum Erzeugen eines ablenkbaren, fokussierten Elektronenstrahls 13, mit welchem die konvex geformte Oberfläche des Bauteils 11 überstrichen werden kann. Innerhalb der Vakuumkammer werden eine Anzahl Sensoren 14 oberhalb der konvex geformten Oberfläche des Bauteils 11 derart angeordnet, dass Elektronen, welche beim Auftreffen des Elektronenstrahls 13 auf die konvexe Oberfläche des Bauteils 11 am Bauteil 11 reflektiert oder zusätzlich als Sekundärelektronen aus dem Bauteil 11 herausgelöst werden, auf die Sensoren 14 auftreffen können. Im Ausführungsbeispiel gemäß Fig. 1 sind lediglich beispielhaft vier Sensoren 14 dargestellt.

Erfindungsgemäß wird der zu glättende Oberflächenbereich des Bauteils 11 zunächst einmal gescannt. Das bedeutet, dass der zu glättende Oberflächenbereich mit dem Elektronenstrahl 13 überstrichen wird, wobei die Flächenenergie, welche mittels des Elektronenstrahls 13 in das Bauteil 11 eingetragen wird, derart eingestellt ist, dass das Überstreichen des Bauteils 11 mit dem Elektronenstrahl 13 nicht zum Aufschmelzen des Bauteilmaterials führt. Die beim Scannen eingestellte Flächenenergie wird auch als zweite Flächenenergie bezeichnet. Das Überstreichen eines zu glättenden Bauteiloberflächenbereichs mittels eines fokussierten Elektronenstrahls erfolgt vorzugsweise linienförmig. Es können alternativ aber auch beliebig andere geometrische Formen und Muster mit dem Elektronenstrahl beim Überstreichen eines zu glättenden Oberflächenbereichs beschrieben werden. Beim Ausführungsbeispiel gemäß Fig. 1 erfolgt das Überstreichen des zu glättenden, konvex geformten Oberflächenbereichs linienförmig, wobei sich die mit dem Elektronenstrahl 13 gezeichneten Linien entlang der Längenausdehnung des Bauteils 11 zum Beispiel in die Tiefe der Zeichenebene erstrecken.

Das linienförmige Überstreichen des zu glättenden Oberflächenbereichs des Bauteils 11 wird realisiert, indem der Ablenkwinkel des Elektronenstrahls 13 von Linie zu Linie verändert wird. In Abhängigkeit vom Ablenkwinkel des Elektronenstrahls und von der Rauheit des zu glättenden Oberflächenbereichs treffen Rückstreu- und Sekundärelektronen auf unterschiedlichen Sensoren 14 bzw. auf einer unterschiedlichen Anzahl von Sensoren 14 auf und bewirken dort einen Stromfluss. Daten, welche den elektrischen Strom, hervorgerufen durch Rückstreu- und Sekundärelektronen, an den Sensoren 14 charakterisieren, werden von den Sensoren 14 an eine Auswerteeinrichtung 15 weitergeleitet. Die Auswerteeinrichtung 15 befindet sich vorzugsweise außerhalb der Vakuumkammer. Je mehr Sensoren 14 beim Zeichnen einer Linie mit dem Elektronenstrahl 13 einen elektrischen Stromfluss verzeichnen, umso rauer ist die mit dem Elektronenstrahl überstrichene Oberfläche des Bauteils 13. Umgekehrt kann geschlussfolgert werden, je weniger Sensoren einen elektrischen Stromfluss verzeichnen bzw. je höher der elektrische Stromfluss bei einem einzelnen Sensor 14 gegenüber anderen Sensoren 14 ist, umso glatter ist die mit dem Elektronenstrahl 13 überstrichene Oberfläche des Bauteils 11. Beim Scannen der Oberfläche des Bauteils 11 mit dem Elektronenstrahl 13 kann so anhand der von den Sensoren 14 übermittelten Daten mittels der Auswerteeinrichtung 15 eine Aussage bezüglich des Istwertes der Rauheit im zu glättenden Oberflächenbereich getroffen und mit einem Sollwert für die Rauheit im zu glättenden Oberflächenbereich verglichen werden.

Erfindungsgemäß wird der zu glättende, konvexe Oberflächenbereich des Bauteils mindestens zweimal mit unterschiedlicher Fokuslänge des Elektronenstrahls 13 gescannt, wobei die von den Sensoren 14 übermittelten Daten der einzelnen Scandurchgänge innerhalb der Auswerteeinrichtung mittels einer mathematischen Operation miteinander verknüpft werden. Es hat sich gezeigt, dass das mehrfache Scannen eines Oberflächenbereichs mit unterschiedlichen Fokuslängen des Elektronenstrahls und das Verknüpfen der dabei erzielten Daten zu genaueren Aussagen bezüglich des Istwertes der Rauheit im gescannten Oberflächenbereich führt, als wenn der Oberflächenbereich nur einmal gescannt wird.

Nachdem der zu glättende Oberflächenbereich des Bauteils 11 mehrfach mit unterschiedlicher Fokuslänge des Elektronenstrahls 13 gescannt; mittels der Auswerteeinrichtung 15 ein Istwert für die Rauheit im zu glättenden Oberflächenbereich ermittelt und mit einem Sollwert für die Rauheit im zu glättenden Oberflächenbereich verglichen wurde, erfolgt das Glätten des Oberflächenbereichs, sofern der Istwert den Sollwert noch nicht erreicht hat.

Hierfür errechnet die Auswerteeinrichtung in Abhängigkeit vom Vergleichsergebnis eine erste Flächenenergie, welche mittels des Elektronenstrahls 13 in den zu glättenden Oberflächenbereich des Bauteils 11 eingetragen und der Oberflächenbereich dadurch aufgeschmolzen werden soll. Dabei wird die erste Flächenenergie umso höher gewählt, je stärker der Istwert der Rauheit im Oberflächenbereich vom Sollwert abweicht. Es ist bekannt, dass die mit einem Elektronenstrahl in ein Bauteil eingetragene Flächenenergie erhöht werden kann, indem beispielsweise der Strahlstrom des Elektronenstrahls erhöht und/oder die Ablenkgeschwindigkeit des Elektronenstrahls verringert werden.

Nachdem die Parameter des Elektronenstrahlgenerators 12 derart eingestellt sind, dass die berechnete erste Flächenenergie mittels des Elektronenstrahls 13 in das Bauteil 11 eingetragen werden kann, erfolgt ein erneutes, lineares Überstreichen des zu glättenden Oberflächenbereichs mit dem Elektronenstrahl 13, infolgedessen der Oberflächenbereich aufgeschmolzen und somit geglättet wird.

Daran schließen sich abermals ein zuvor beschriebenes, mindestens zweimaliges Scannen des zu glättenden Oberflächenbereichs; ein Berechnen des Istwertes der Rauheit im zu glättenden Oberflächenbereich; ein Vergleich des berechneten Istwertes der Rauheit mit dem Sollwert der Rauheit; ein Berechnen der ersten Flächenenergie für den Elektronenstrahl in Abhängigkeit vom Vergleichsergebnis und ein Aufschmelzen des zu glättenden Oberflächenbereichs an. Dieser Kreislauf wird so lange fortgesetzt, bis der Istwert der Rauheit im zu glättenden Oberflächenbereich den Sollwert für die Rauheit im zu glättenden Oberflächenbereich erreicht hat.

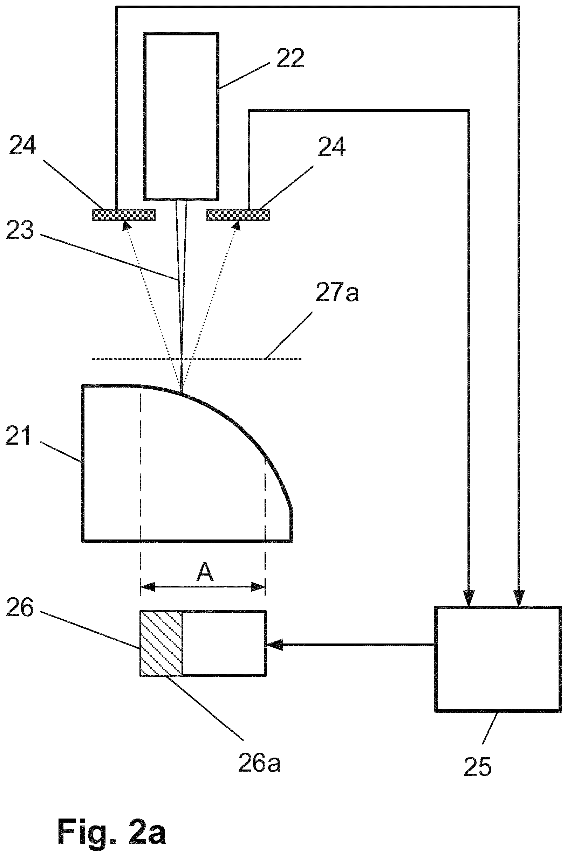

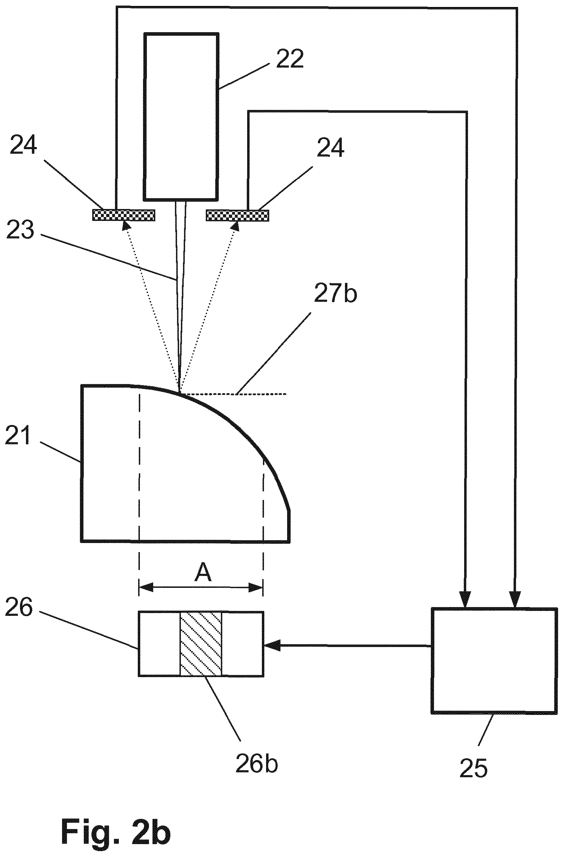

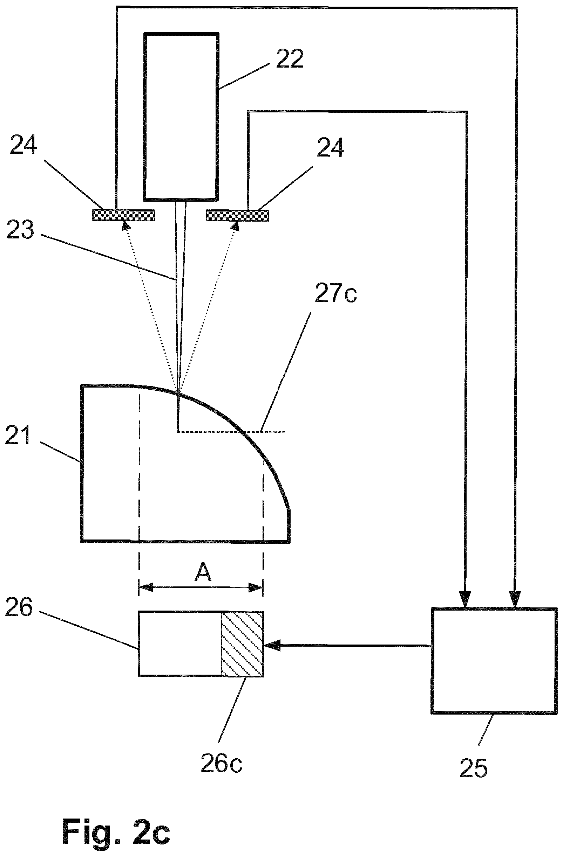

Die Fig. 2a, 2b und 2c zeigen eine schematische Darstellung einer Vorrichtung, mittels der eine alternative Ausführungsform des erfindungsgemäßen Verfahrens durchgeführt werden kann. Ein beispielsweise mittels additiver Fertigung hergestelltes und aus einem elektrisch leitfähigem Material bestehendes Bauteil 21, welches einen konstanten Querschnitt gemäß der Fig. 2a, 2b und 2c aufweist und welches sich bezüglich seiner Längenausdehnung in die Tiefe der Zeichenebene der Fig. 2a, 2b und 2c erstreckt, weist an einer Seite eine konvex geformte Oberfläche auf. Da die konvex geformte Oberfläche eine zu hohe Rauheit aufweist, soll diese Oberfläche in einem Oberflächenbereich mit der Ausdehnung A geglättet werden. Dazu wird das Bauteil 21 erfindungsgemäß in eine Vakuumkammer eingeschleust. In der Vakuumkammer angeordnet oder an der Vakuumkammer befestigt ist mindestens ein Elektronenstrahlgenerator 22, zum Erzeugen eines ablenkbaren, fokussierten Elektronenstrahls 23, mit welchem die konvex geformte Oberfläche im Oberflächenbereich mit der Ausdehnung A überstrichen werden kann. Innerhalb der Vakuumkammer werden eine Anzahl Sensoren 24 oberhalb der konvex geformten Oberfläche des Bauteils 21 derart angeordnet, dass Elektronen, welche beim Auftreffen des Elektronenstrahls 23 auf die konvexe Oberfläche des Bauteils 21 am Bauteil 21 reflektiert oder zusätzlich als Sekundärelektronen aus dem Bauteil 21 herausgelöst werden, auf die Sensoren 24 auftreffen können. Im Ausführungsbeispiel gemäß der Fig. 2a, 2b und 2c sind beispielhaft, auch der besseren Übersichtlichkeit wegen, lediglich zwei Sensoren 24 dargestellt.

Erfindungsgemäß wird der zu glättende Oberflächenbereich des Bauteils 21 zunächst einmal gescannt. Das bedeutet, dass der zu glättende Oberflächenbereich mit der Ausdehnung A mit dem Elektronenstrahl 23 überstrichen wird, wobei die Flächenenergie, welche mittels des Elektronenstrahls 23 in das Bauteil 21 eingetragen wird, derart eingestellt ist, dass das Überstreichen des Bauteils 21 mit dem Elektronenstrahl 23 nicht zum Aufschmelzen des Bauteilmaterials führt. Wie zuvor schon ausgeführt, wird die beim Scannen eingestellte Flächenenergie auch als zweite Flächenenergie bezeichnet. Auch beim Ausführungsbeispiel gemäß der Fig. 2a, 2b und 2c erfolgt das Überstreichen des zu glättenden, konvex geformten Oberflächenbereichs linienförmig, wobei sich die mit dem Elektronenstrahl 23 gezeichneten Linien entlang der Längenausdehnung des Bauteils 21 zum Beispiel in die Tiefe der Zeichenebene erstrecken.

Das linienförmige Überstreichen des zu glättenden Oberflächenbereichs des Bauteils 21 wird realisiert, indem der Ablenkwinkel des Elektronenstrahls 23 von Linie zu Linie verändert wird. In Abhängigkeit vom Ablenkwinkel des Elektronenstrahls und von der Rauheit des zu glättenden Oberflächenbereichs treffen Rückstreu- und Sekundärelektronen auf unterschiedliche Sensoren 24 bzw. auf einer unterschiedlichen Anzahl von Sensoren 24 auf und bewirken dort einen Stromfluss. Daten, welche den elektrischen Strom, hervorgerufen durch Rückstreu- und Sekundärelektronen, an den Sensoren 24 charakterisieren, werden von den Sensoren 24 an eine Auswerteeinrichtung 25 weitergeleitet. Die Auswerteeinrichtung 25 befindet sich außerhalb der Vakuumkammer.

Die Auswerteeinrichtung 25 umfasst eine bekannte Grafiksoftware, mittels der aus den von den Sensoren 24 übermittelten Daten ein dreidimensionales Abbild 26 des mittels des Elektronenstrahls 23 gescannten Oberflächenbereichs mit der Ausdehnung A erzeugt werden kann. In den Fig. 2a, 2b und 2c ist das mittels der Auswerteeinrichtung 25 erzeugte dreidimensionale Abbild 26 des Oberflächenbereichs mit der Ausdehnung A als Draufsicht lediglich schematisch dargestellt.

Erfindungsgemäß wird der Oberflächenbereich mit der Ausdehnung A mehrfach mittels des Elektronenstrahls 23 gescannt, wobei jedes Mal eine andere Fokuslänge des Elektronenstrahls gewählt wird.

In Fig. 2a ist ein Scannen des Bauteils 21 schematisch dargestellt, bei dem die Fokuslänge des Elektronenstrahls 23 auf eine Länge 27a eingestellt ist. Der Fokus des Elektronenstrahls 23 weist hierbei eine Länge auf, die kürzer ist als der Abstand vom Elektronenstrahlgenerator 22 zum Bauteil 21. Bei diesem Scandurchgang wird mittels der Auswerteeinrichtung 25 ein dreidimensionales Abbild 26 des gescannten Oberflächenbereichs mit der Ausdehnung A erzeugt, welches lediglich im schraffiert dargestellten Teilbereich 26a eine hohe Detailschärfe aufweist.

Ein zweiter Scandurchgang ist in Fig. 2b schematisch dargestellt, bei dem die Fokuslänge des Elektronenstrahls 23 auf eine Länge 27b eingestellt ist. Der Fokus des Elektronenstrahls 23 weist hierbei eine Länge auf, die genau so lang ist wie der Abstand vom Elektronenstrahlgenerator 22 zum Bauteil 21. Bei diesem Scandurchgang wird mittels der Auswerteeinrichtung 25 ein dreidimensionales Abbild 26 des gescannten Oberflächenbereichs mit der Ausdehnung A erzeugt, welches lediglich im schraffiert dargestellten Teilbereich 26b eine hohe Detailschärfe aufweist.

Bei einem dritten Scandurchgang, welcher in Fig. 2c schematisch dargestellt ist, wurde der Fokus des Elektronenstrahls 23 schließlich auf eine Länge 27c eingestellt. Der Fokus des Elektronenstrahls 23 weist hierbei eine Länge auf, die größer ist als der Abstand vom Elektronenstrahlgenerator 22 zum Bauteil 21. Bei diesem Scandurchgang wird mittels der Auswerteeinrichtung 25 ein dreidimensionales Abbild 26 des gescannten Oberflächenbereichs mit der Ausdehnung A erzeugt, welches lediglich im schraffiert dargestellten Teilbereich 26c eine hohe Detailschärfe aufweist.

Mittels der Grafiksoftware der Auswerteeinrichtung 25 werden die schraffiert dargestellten Teilbereiche 26a, 26b, 26c mit hoher Detailschärfe aus den drei Scandurchgängen zu einem Gesamtabbild des Oberflächenbereichs mit der Ausdehnung A zusammengefügt und somit ein durchgängig detailscharfes dreidimensionales Gesamtabbild des gescannten Oberflächenbereichs erzeugt. Aus einem solchen dreidimensionalen Gesamtabbild lassen sich Angaben zur Oberflächenform und somit auch zum Istzustand der Rauheit im gescannten Oberflächenbereich sowie Angaben zur Ausrichtung des gescannten Oberflächenbereichs im Verhältnis zur Einfallsrichtung des Elektronenstrahls ableiten.

Wurde aus dem erzeugten dreidimensionalen Gesamtabbild mittels der Auswerteeinrichtung 25 ein Istwert für die Rauheit im zu glättenden Oberflächenbereich ermittelt und mit einem Sollwert für die Rauheit im zu glättenden Oberflächenbereich verglichen, erfolgt das Glätten des Oberflächenbereichs, sofern der Istwert den Sollwert noch nicht erreicht hat.

Hierfür errechnet die Auswerteeinrichtung in Abhängigkeit vom Vergleichsergebnis aus Istwert und Sollwert eine erste Flächenenergie, welche mittels des Elektronenstrahls 23 in den zu glättenden Oberflächenbereich des Bauteils 21 eingetragen und der Oberflächenbereich dadurch aufgeschmolzen werden soll.

Nachdem die Parameter des Elektronenstrahlgenerators 22 derart eingestellt sind, dass die berechnete erste Flächenenergie mittels des Elektronenstrahls 23 in das Bauteil 21 eingetragen werden kann, erfolgt ein erneutes, lineares Überstreichen des zu glättenden Oberflächenbereichs mit dem Elektronenstrahl 23, infolgedessen der Oberflächenbereich aufgeschmolzen und somit geglättet wird.

Daran schließen sich abermals ein zuvor beschriebenes, mindestens zweimaliges Scannen des zu glättenden Oberflächenbereichs; ein Erzeugen eines dreidimensionalen Gesamtabbildes des gescannten Oberflächenbereichs; ein Berechnen eines Istwertes der Rauheit im zu glättenden Oberflächenbereich; ein Vergleich des berechneten Istwertes der Rauheit mit dem Sollwert der Rauheit; ein Berechnen der ersten Flächenenergie für den Elektronenstrahl in Abhängigkeit vom Vergleichsergebnis und ein Aufschmelzen des zu glättenden Oberflächenbereichs an. Dieser Kreislauf wird so lange fortgesetzt, bis der Istwert der Rauheit im zu glättenden Oberflächenbereich den Sollwert für die Rauheit im zu glättenden Oberflächenbereich erreicht hat.

Wie bereits dargelegt wurde, lässt sich aus einem mittels der Auswerteeinrichtung 25 erzeugten dreidimensionalen Gesamtabbildes eines gescannten Oberflächenbereichs auch die Ausrichtung des gescannten Oberflächenbereichs im Bezug zur Einfallsrichtung des Elektronenstrahls ableiten.

Bei einer Ausführungsform wird das Bauteil 21 mittels einer Halteeinrichtung innerhalb der Vakuumkammer angeordnet, welche die Position des Bauteils 21 innerhalb der Vakuumkammer dreidimensional verändern kann. Nach dem mehrmaligen Scannen eines Bauteiloberflächenbereichs von Bauteil 21, dem Erstellen eines dreidimensionalen Abbildes des Oberflächenbereichs und dem Ermitteln der Ausrichtung des Oberflächenbereichs in Bezug auf die Einfallsrichtung des Elektronenstrahls 23, kann auch eine Aussage zur dreidimensionalen Ist-Ausrichtung des Bauteils 21 innerhalb der Vakuumkammer abgeleitet und mit einer Soll-Ausrichtung des Bauteils verglichen werden. In Abhängigkeit vom Vergleichsergebnis wird dann mittels der Auswerteeinrichtung ein Signal gebildet, mit dem die Halteeinrichtung das Bauteil 21 zur Soll-Ausrichtung innerhalb der Vakuumkammer führt.

Auf diese Weise ist es beispielsweise möglich, das Bauteil 21 innerhalb der Vakuumkammer in eine gewünschte Startposition für das Bearbeiten mit dem Elektronenstrahl 23 zu bringen oder auch eine Lageänderung des Bauteils 21 vorzunehmen und nach erfolgter Lageänderung die aktuelle räumliche Anordnung des Bauteils 21 zu überprüfen, wenn das Bauteil 21 nach dem Bearbeiten eines Oberflächenbereichs zum Bearbeiten eines anderen Oberflächenbereichs in eine andere Position überführt werden soll.

Alternativ oder zusätzlich ist es auch möglich, den Elektronenstrahlgenerator 22 mit einer dreidimensional veränderbaren Haltevorrichtung innerhalb der Vakuumkammer anzuordnen und dessen Position in Bezug zum Bauteil 21 mittels des erfindungsgemäßen Verfahrens zu kontrollieren bzw. einzustellen.

## Patentansprüche

1. Verfahren zum Glätten eines Oberflächenbereichs eines Bauteils (11; 21), welches zumindest innerhalb des Oberflächenbereichs aus einem elektrisch leitfähigen Material besteht, wobei der Oberflächenbereich des Bauteils (11; 21) innerhalb einer Vakuumkammer mittels mindestens eines fokussierten Elektronenstrahls (13; 23) mit einer ersten Flächenenergie überstrichen wird, die ein Aufschmelzen des Bauteilmaterials innerhalb des Oberflächenbereichs bewirkt, wobei
a) der Oberflächenbereich vor dem Aufschmelzen mindestens zweimal mit dem Elektronenstrahl (13; 23) mit jeweils unterschiedlicher Fokuslänge (27a; 27b; 27c) des Elektronenstrahls (13; 23) überstrichen wird, wobei
b) eine zweite Flächenenergie für den Elektronenstrahl (13; 23) eingestellt wird, die kein Aufschmelzen des Bauteilmaterials im Oberflächenbereich bewirkt, wobei
c) mittels einer Anzahl von innerhalb der Vakuumkammer angeordneter Sensoren (14; 24) Daten erfasst werden, die den elektrischen Strom, hervorgerufen durch die auf die Sensoren (14; 24) auftreffenden Rückstreuelektronen, charakterisieren, wobei
d) innerhalb einer Auswerteeinrichtung (15; 25) aus den von den Sensoren (14; 24) erfassten Daten ein Istwert für die Rauheit innerhalb des Oberflächenbereichs abgeleitet, der Istwert der Rauheit mit einem Sollwert der Rauheit verglichen und wenn der Istwert der Rauheit nicht den Sollwert der Rauheit erreicht hat, in Abhängigkeit vom Vergleichsergebnis, ein Wert für die erste Flächenenergie ermittelt wird, danach
e) der Oberflächenbereich mit dem Elektronenstrahl (13; 23) mit der ersten Flächenenergie überstrichen wird, wonach mit Verfahrensschritt a) fortgesetzt wird.

2. Verfahren nach Anspruch 1, **dadurch gekennzeichnet, dass** der Elektronenstrahl mit einem Winkel kleiner 90° zum Oberflächenbereich des Bauteils hin ausgerichtet wird.

3. Verfahren nach Anspruch 2, **dadurch gekennzeichnet, dass** der Elektronenstrahl mit einem Winkel im Bereich von 45° bis 90° zum Oberflächenbereich des Bauteils hin ausgerichtet wird.

4. Verfahren nach Anspruch 3, **dadurch gekennzeichnet, dass** das Bauteil (21) mittels einer Halteeinrichtung innerhalb der Vakuumkammer angeordnet wird, welche die Position des Bauteils innerhalb der Vakuumkammer dreidimensional verändern kann.

5. Verfahren nach Anspruch 4, **dadurch gekennzeichnet, dass** das Bauteil nach dem Anordnen mittels der Halteeinrichtung innerhalb der Vakuumkammer
f) mit dem Elektronenstrahl (23) überstrichen wird;
g) mittels der dabei von den Sensoren (24) erfassten Daten innerhalb der Auswerteeinrichtung (25) eine Aussage zur dreidimensionalen Ist-Ausrichtung des Bauteils (21) innerhalb der Vakuumkammer abgeleitet und mit einer Soll-Ausrichtung des Bauteils (21) verglichen wird;
h) in Abhängigkeit vom Vergleichsergebnis ein Signal gebildet wird, mit dem die Halteeinrichtung das Bauteil (21) zur Soll-Ausrichtung innerhalb der Vakuumkammer führt.

## Claims

1. Method for smoothing a surface region of a component (11; 21) consisting of an electrically conductive material at least within the surface region, wherein within a vacuum chamber the surface region of the component (11; 21) is swept over by means of at least one focused electron beam (13; 23) with a first surface energy, which causes melting of the component material within the surface region, wherein
a) before melting the surface region is swept over at least twice by the electron beam (13; 23), in each case with a different focal length (27a; 27b; 27c) of the electron beam (13; 23), wherein
b) a second surface energy is set for the electron beam (13; 23), which second surface energy does not cause melting of the component material in the surface region, wherein
c) data are acquired by means of a number of sensors (14; 24) arranged within the vacuum chamber, said data characterizing the electric current caused by the backscattered electrons impinging on the sensors (14; 24), wherein
d) within an evaluation device (15; 25), an actual value for the roughness in the surface region is derived from the data acquired by the sensors (14; 24), the actual value of the roughness is compared with a target value of the roughness and, if the actual value of the roughness has not reached the target value of the roughness, a value for the first surface energy is determined depending on the result of the comparison, and thereafter
e) the surface region is swept over by the electron beam (13; 23) with the first surface energy, after which the method continues with method step a) .

2. Method according to Claim 1, **characterized in that** the electron beam is oriented towards the surface region of the component at an angle of less than 90°.

3. Method according to Claim 2, **characterized in that** the electron beam is oriented towards the surface region of the component at an angle in the range of 45° to 90°.

4. Method according to Claim 3, **characterized in that** the component (21) is arranged within the vacuum chamber by means of a holding device, which can change the position of the component within the vacuum chamber three-dimensionally.

5. Method according to Claim 4, **characterized in that** the component, after being arranged within the vacuum chamber by means of the holding device,
f) is swept over by the electron beam (23);
g) by means of the data acquired by the sensors (24) in the process, within the evaluation device (25), an assessment concerning the three-dimensional actual orientation of the component (21) within the vacuum chamber is derived and compared with a target orientation of the component (21);
h) a signal is formed depending on the result of the comparison, by means of which signal the holding device guides the component (21) to the target orientation within the vacuum chamber.

## Revendications

1. Procédé de lissage d'une zone de surface d'un composant (11 ; 21) qui comprend un matériau électriquement conducteur au moins à l'intérieur de la zone de surface, la zone de surface du composant (11 ; 21) étant balayée à l'intérieur d'une chambre à vide au moyen d'au moins un faisceau d'électrons focalisé (13 ; 23) ayant une première énergie de surface qui fait fondre le matériau du composant à l'intérieur de la zone de surface,
a) la zone de surface étant balayée avant la fusion au moins deux fois avec le faisceau d'électrons (13 ; 23) à chaque fois avec une longueur focale différente (27a ; 27b ; 27c) du faisceau d'électrons (13 ; 23),
b) une deuxième énergie de surface du faisceau d'électrons (13 ; 23) étant réglée qui ne fait pas fondre le matériau du composant dans la zone de surface,
c) un certain nombre de capteurs (14 ; 24), disposés à l'intérieur de la chambre à vide, permettant d'acquérir des données qui caractérisent le courant électrique généré par les électrons rétrodiffusés incidents aux capteurs (14 ; 24),
d) à l'intérieur d'une unité d'évaluation (15 ; 25), une valeur réelle de la rugosité à l'intérieur de la zone de surface étant dérivée des données acquises par les capteurs (14 ; 24), la valeur réelle de la rugosité étant comparée à une valeur cible de la rugosité et, si la valeur réelle de la rugosité n'a pas atteint la valeur cible de la rugosité, une valeur de la première énergie de surface étant alors déterminée en fonction du résultat de la comparaison, puis
e) la zone de surface étant balayée par le faisceau d'électrons (13 ; 23) avec la première énergie de surface, après quoi un retour à l'étape de procédé a) est effectué.

2. Procédé selon la revendication 1, **caractérisé en ce que** le faisceau d'électrons est orienté avec un angle inférieur à 90° par rapport à la zone de surface du composant.

3. Procédé selon la revendication 2, **caractérisé en ce que** le faisceau d'électrons est orienté avec un angle compris entre 45° et 90° par rapport à la zone de surface du composant.

4. Procédé selon la revendication 3, **caractérisé en ce que** le composant (21) est disposé à l'intérieur de la chambre à vide au moyen d'une unité de retenue qui peut modifier la position du composant de manière tridimensionnelle à l'intérieur de la chambre à vide.

5. Procédé selon la revendication 4, **caractérisé en ce que**, après avoir été disposé à l'intérieur de la chambre à vide au moyen de l'unité de retenue, le composant
f) est balayé avec le faisceau d'électrons (23) ;
g) au moyen des données acquises par les capteurs (24) dans le dispositif d'évaluation (25), une information relative à l'orientation réelle tridimensionnelle du composant (21) à l'intérieur de la chambre à vide est déduite et comparée à une orientation cible du composant (21) ;
h) en fonction du résultat de la comparaison, un signal est formé avec lequel l'unité de retenue dirige le composant (21) suivant l'orientation souhaitée à l'intérieur de la chambre à vide.
